(19) Europäisches Patentamt
European Patent Office
Office européen des brevets

(11) **EP 3 428 713 A1**

(12) **EUROPÄISCHE PATENTANMELDUNG**

(43) Veröffentlichungstag:
**16.01.2019 Patentblatt 2019/03**

(51) Int Cl.:
***G02B 27/09*** *(2006.01)*  ***B23K 26/073*** *(2006.01)*

(21) Anmeldenummer: **18179273.0**

(22) Anmeldetag: **22.06.2018**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **14.07.2017 DE 102017115964**

(71) Anmelder: **LIMO GmbH**
**44319 Dortmund (DE)**

(72) Erfinder:
• IVANENKO, Mikhail
**45276 Essen (DE)**
• GRIMM, Viacheslav
**198255 Sankt Petersburg (RU)**

(74) Vertreter: **Schäperklaus, Jochen et al**
**Fritz Patent- und Rechtsanwälte**
**Partnerschaft mbB**
**Postfach 1580**
**59705 Arnsberg (DE)**

(54) **VORRICHTUNG ZUR ERZEUGUNG EINER LINIENFÖRMIGEN INTENSITÄTSVERTEILUNG EINER LASERSTRAHLUNG**

(57)   Vorrichtung zur Erzeugung einer linienförmigen Intensitätsverteilung einer Laserstrahlung, umfassend zwei Strahltransformationsvorrichtungen (2, 3), die zueinander beabstandet sind, Fokussiermittel (5a, 5b, 6a, 6b), die die durch die beiden Strahltransformationsvorrichtungen (2, 3) hindurch getretene Laserstrahlung in eine linienförmige Intensitätsverteilung fokussieren können, wobei die Vorrichtung derart gestaltet ist, dass die Linienbreite in Linienquerrichtung der linienförmigen Intensitätsverteilung durch Veränderung des Abstands zwischen den beiden Strahltransformationsvorrichtungen (2, 3) verändert werden kann.

Fig. 1a

Fig. 1b

**Beschreibung**

Die vorliegende Erfindung betrifft eine Vorrichtung zur Erzeugung einer linienförmigen Intensitätsverteilung einer Laserstrahlung gemäß dem Oberbegriff des Anspruchs 1.

Für die Erzeugung von langen, homogenen und schmalen Laserlinien mit besonders großer Schärfentiefe können refraktive oder reflektive Strahltransformationsvorrichtungen eingesetzt werden, die die Modenzusammensetzung von Multimode-Lasern ($M^2$ > 10), beispielsweise von Festkörperlasern, so umordnen, dass die Strahlqualität (beziehungsweise die Beugungsmaßzahl oder die Modenanzahl oder die Strahldivergenz) für eine Querrichtung (Y) deutlich reduziert und für die andere (X) steigt. Als Ergebnis kann mit einer dahinter angeordneten Optik die Strahlung in X-Richtung (lange Linienachse) sehr gut homogenisiert werden. In Y-Richtung (Linienquerschnitt) kann die Strahlung sehr gut fokussiert und eine große Schärfentiefe erreicht werden. Es ist auch vorteilhaft, dass ein großer Arbeitsabstand mit einfach aufgebauten, fokussierenden Optiken mit niedriger NA erreicht werden kann. Eine entsprechende Vorrichtung findet sich in der EP 1 896 893 A1.

Refraktive Strahltransformatoren aus zwei Linsenarrays sind aus der US 5,513,201 bekannt. Sie dienen dazu, die Strahlung eines Laserdiodenarrays zu bündeln. Aus der EP 1 006 382 A1 ist ein weiterer Strahltransformator mit zwei Bikonvex-Zylinderlinsenarrays bekannt.

Das der vorliegenden Erfindung zugrundeliegende Problem ist die Schaffung einer Vorrichtung der eingangs genannten Art, mit der die Linienbreite in Linienquerrichtung der linienförmigen Intensitätsverteilung beeinflusst werden kann.

Dies wird erfindungsgemäß durch eine Vorrichtung der eingangs genannten Art mit den kennzeichnenden Merkmalen des Anspruchs 1 erreicht. Die Unteransprüche betreffen bevorzugte Ausgestaltungen der Erfindung.

Gemäß Anspruch 1 ist vorgesehen, dass die Vorrichtung derart gestaltet ist, dass die Linienbreite in Linienquerrichtung der linienförmigen Intensitätsverteilung durch Veränderung des Abstands zwischen den beiden Strahltransformationsvorrichtungen verändert werden kann. Dadurch kann auf einfache Weise die Linienbreite in Linienquerrichtung der linienförmigen Intensitätsverteilung beeinflusst werden.

Es ergibt sich insbesondere eine stufenlose und technisch leicht realisierbare Steuerung der Linienbreite bei der Formung von schmalen Laserlinien mit Multimode-Lasern wie beispielsweise eines Festkörperlasers. Auch Fertigungstoleranzen der Strahltransformationsvorrichtungen sowie Fertigungs- und Justagefehler von Optikmitteln zwischen der Laserlichtquelle und den Strahltransformationsvorrichtungen, die die Divergenz in X-Richtung beeinflussen, wie auch eine vom Design der Vorrichtung abweichende Laserdivergenz lassen sich auf diese Weise optisch kompensieren. Außerdem kann dadurch zusätzlich die Lichtintensität in den Strahltransformationsvorrichtungen so reduziert werden, dass sie unter der Beschädigungsschwelle des benutzten Materials liegt.

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen:

Fig. 1a    eine schematische Seitenansicht einer Ausführungsform einer erfindungsgemäßen Vorrichtung;

Fig. 1b    eine schematische Draufsicht auf die Vorrichtung gemäß Fig. 1a;

Fig. 2    eine Ansicht des Querschnitts der Laserstrahlung auf der Eintrittsfläche der ersten der beiden Strahltransformationsvorrichtungen;

Fig. 3a, 3b    Skizzen zur Verdeutlichung der Strahltransformation;

Fig. 4a    eine schematische Ansicht des Querschnitts der Laserstrahlung auf der Eintrittsfläche der ersten der beiden Strahltransformationsvorrichtungen;

Fig. 4b    eine schematische Ansicht des Querschnitts der Laserstrahlung auf der Austrittsfläche der zweiten der beiden Strahltransformationsvorrichtungen;

Fig. 5    eine schematische, perspektivische Ansicht eines Teils der Vorrichtung;

Fig. 6    einen Schnitt durch eine erste Ausführungsform von Strahltransformationsvorrichtungen;

Fig. 7    einen Schnitt durch eine zweite Ausführungsform von Strahltransformationsvorrichtungen;

Fig. 8    einen nicht maßstabsgerechten, beispielhaften Strahlengang durch die beiden Strahltransformationsvorrichtungen und die Fokussiermittel;

Fig. 9    ein Diagramm, dass die Abhängigkeit der Strahltaille in Linienquerrichtung in Abhängigkeit von dem Abstand der beiden Strahltransformationsvorrichtungen zueinander darstellt

Fig. 10    eine perspektivische Ansicht der beiden Strahltransformationsvorrichtungen.

In den Figuren sind gleiche oder funktional gleiche Teile mit gleichen Bezugszeichen versehen. Dabei sind in einige der Figuren kartesische Koordinatensysteme eingezeichnet, um die Orientierung zu erleichtern.

Die zu erzeugende linienförmige Intensitätsverteilung einer Laserstrahlung weist in den kartesischen Koordinatensystemen eine sich in X-Richtung erstreckende Linienlängsrichtung und eine sich in Y-Richtung erstreckende Linienquerrichtung auf.

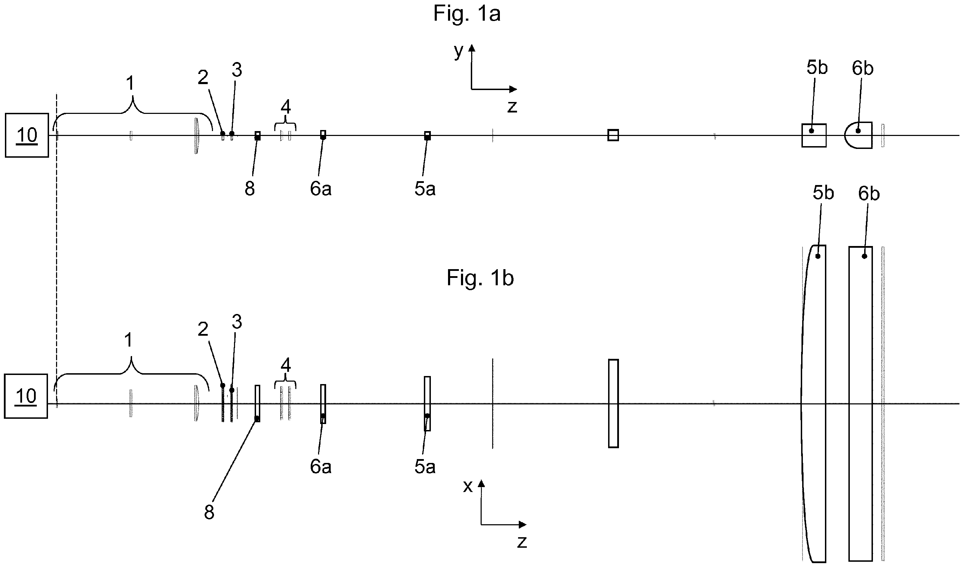

Die in Fig. 1 abgebildete Vorrichtung umfasst eine lediglich schematisch abgebildete Laserlichtquelle 10, ein anamorphotisches Teleskop 1, eine erste und eine zweite Strahltransformationsvorrichtung 2, 3 sowie Homogenisatormittel 4, die insbesondere auf die X-Richtung beziehungsweise die Linienlängsrichtung wirken. Die Vorrichtung umfasst weiterhin Fourieroptikmittel 5a, 5b für die X-Richtung und Fokussiermittel 6a, 6b für die Y-Richtung.

Die Laserlichtquelle 10 kann beispielsweise als von Laserdioden gepumpter Festkörperlaser ausgebildet sein. Die Homogenisatormittel 4 können beispielsweise zwei in Ausbreitungsrichtung der Laserstrahlung beziehungsweise in Z-Richtung hintereinander angeordnete Arrays von Zylinderlinsen umfassen, deren Zylinderachsen sich in Y-Richtung erstrecken.

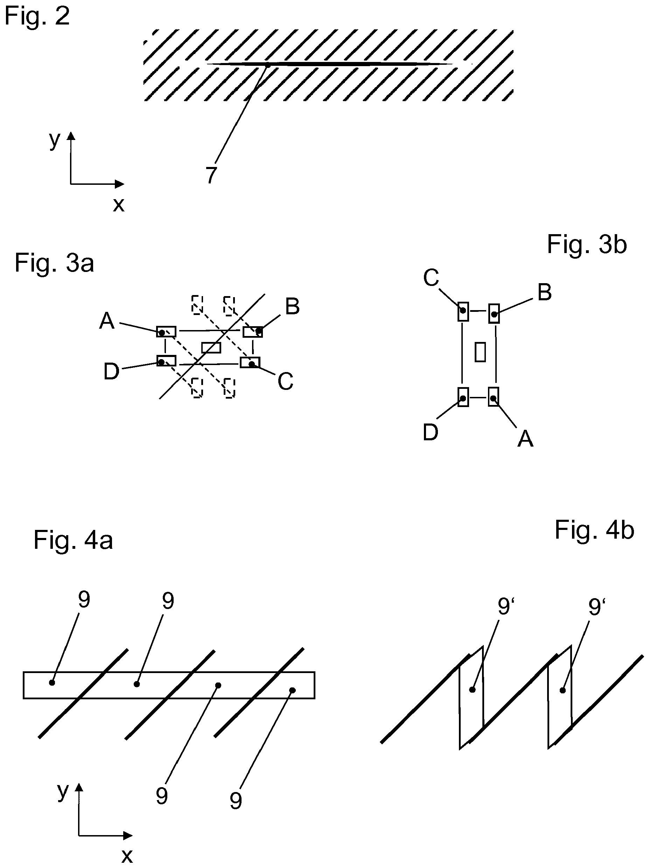

Das anamorphotische Teleskop 1 dient der Gestaltung einer schmalen elliptische Taille 7 in der langen Achse X an der Eintrittsfläche der ersten Strahltransformationsvorrichtung 2 (siehe dazu Fig. 2). Die Strahltransformationsvorrichtungen 2, 3 können als zwei refraktive oder reflektive Arrays ausgebildet sein.

Hinter den Strahltransformationsvorrichtungen 2, 3 und vor den Homogenisatormitteln 4 können auf die X-Richtung wirkende Optikmittel 8 vorgesehen sein.

Insbesondere besteht jede der Strahltransformationsvorrichtungen 2, 3 aus einem refraktiven Array. Am ersten Array wird die elliptische Taille 7 in mehrere, insbesondere in m, Teilstrahlen 9 beziehungsweise Segmente in der X-Richtung zerlegt. Alternativ kann die Laserstrahlung vor den Arrays mit einer zusätzlichen segmentierenden Optik zerlegt werden. Im weiteren werden die Teilstrahlen 9 so transformiert, dass sie am Ausgang der Strahltransformationsvorrichtungen 2, 3 im Vergleich zu dem Eingang relativ zu einer 45°-Achse in der XY-Ebene gespiegelt sind. In Fig. 3a und 3b wird dies durch die Transformation der Ecken A, B, C, D des Querschnitts eines Teilstrahls 9 angedeutet. In Fig. 4a und 4b sind eingangsseitig noch aneinandergrenzende Teilstrahlen 9 und in Fig. 4b sind ausgangsseitig transformierte Teilstrahlen 9' angedeutet.

Im Zwischenraum der Arrays werden die Teilstrahlen in einem bestimmten Maß fokussiert.

Die Transformation ändert die Beugungsmaßzahl $M^2$ für das gesamte Lichtbündel anisotrop. Dabei wird $M^2$ insbesondere m-fach reduziert für die Y- und m-fach vergrößert für die X-Richtung. Es kann auch so dargestellt werden, dass die kleine Eingangsdivergenz $\theta_x$ hinsichtlich der X-Richtung beziehungsweise der langen Achse der elliptischen Taille 7 einerseits und die große Eingangsdivergenz $\theta_y$ hinsichtlich der Y-Richtung beziehungsweise der schmalen Achse der elliptischen Taille 7 nach der Transformation vertauscht sind.

$$\theta_x \rightarrow \theta'_y, \; \theta_y \rightarrow \theta'_x$$

$$(1)$$

Eine bevorzugte Ausführung der Strahltransformationsvorrichtungen 2, 3 besteht aus zwei Arrays von Zylinderlinsen, deren Zylinderachsen unter einem Winkel von 45° zur X-Richtung und zur Y-Richtung ausgerichtet sind (siehe dazu Fig. 2, Fig. 5 und Fig. 10). Dabei sind die Zylinderachsen des die erste Strahltransformationsvorrichtung 2 bildenden Arrays parallel zu den Zylinderachsen des die zweite Strahltransformationsvorrichtung 3 bildenden Arrays ausgerichtet.

Die einzelnen Zylinderlinsenpaare der Arrays bilden für die Teilstrahlen Keppler-Teleskope mit einer Vergrößerung -1:

$$\frac{d}{2} = \frac{R_1}{n-1}$$

$$R_1 = -R_2 = \frac{n-1}{d} \cdot d$$

$$k_1 = k_2 = -n^2$$

$$(2)$$

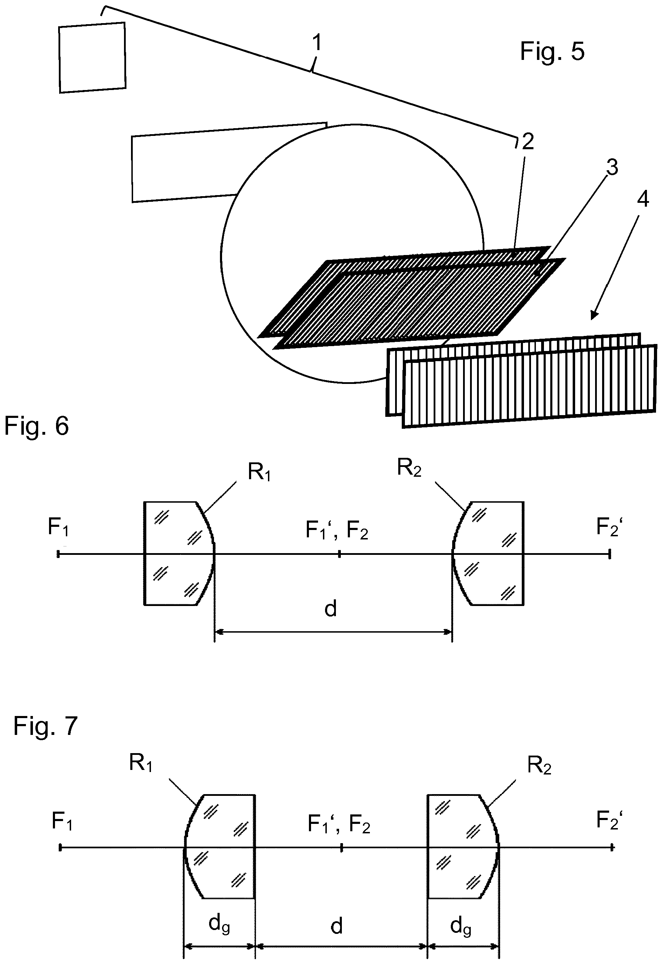

Die Gleichungen (2) gelten nur für die Ausführungsform gemäß Fig. 6. Die Ausführung gemäß Fig. 6 hat den Vorteil, dass die Energiedichte an den inneren Linsenflächen geringer ist als bei der Ausführungsform gemäß Fig. 7. In Fig. 6 und Fig. 7 sind die Radien der Linsenflächen der ersten und der zweiten Strahltransformationsvorrichtung 2, 3 mit $R_1$ und $R_2$ bezeichnet. Mit d ist der Abstand zwischen den einander gegenüberliegenden Linsenflächen bezeichnet. Mit $F_1$, $F_1$', $F_2$ und $F_2$' sind in Fig. 6 und Fig. 7 die die vorderen und hinteren Brennweiten der Zylinderlinsen bezeichnet. Mit $d_g$ sind die Dicken der Zylinderlinsen in Fig. 7 bezeichnet.

Auch eine Ausführungsform mit gekreuzten Treppenspiegeln mit konkaven Stufen ist in Prinzip möglich. Allerdings sollten die konkaven Stufen eine geeignete Form erhalten, um Aberrationen kompensieren zu können.

Die Strahldivergenz am Ausgang nach Gleichung (1) gilt, wenn der Abstand d zwischen den Linsenarrays so gewählt wird, dass die teleskopische Bedingungen, beispielsweise gemäß Gleichung (2) für die Konfiguration gemäß Fig. 6, genau erfüllt sind.

Durch Feintuning des Abstandes d kann einerseits die Divergenz der Ausgangsstrahlen geändert werden. Andererseits können Fertigungsfehler des Radius korrigiert werden. Weiterhin können Fertigungs- und Justagefehler von Optikmitteln zwischen der Laserlichtquelle und den Strahltransformationsvorrichtungen, die die Divergenz in X-Richtung beeinflussen, wie auch eine vom Design der Vorrichtung abweichende Laserdivergenz optisch kompensiert werden.

Bei einer Änderung des Abstandes $\Delta$ = d-$d_0$ bekommen die Teilstrahlen 9, 9' nach den Strahltransformationsvorrichtungen 2, 3 eine zusätzliche Divergenz:

$$\delta\theta = -\Delta * P/(2f_T^2),$$

$$(3)$$

wobei P der Pitch beziehungsweise der Mittenabstand der Zylinderlinsen der Strahltransformationsvorrichtung 2, 3 senkrecht zu den Zylinderachsen und $f_T$ die Brennweite der Zylinderlinsen der Strahltransformationsvorrichtung 2, 3 sind.

Die resultierende Divergenz für Y

$$\theta'_y + \delta\theta$$

$$(4)$$

steigt bei Verkleinerung des Abstandes. Bei steigendem Abstand beziehungsweise bei positivem $\Delta$ reduziert sich die Divergenz zuerst. Nach dem Erreichen des Wertes $\delta\theta$ = -$\theta'_y$ beginnt die Divergenz wieder zu steigen (formell mit "-" Zeichen).

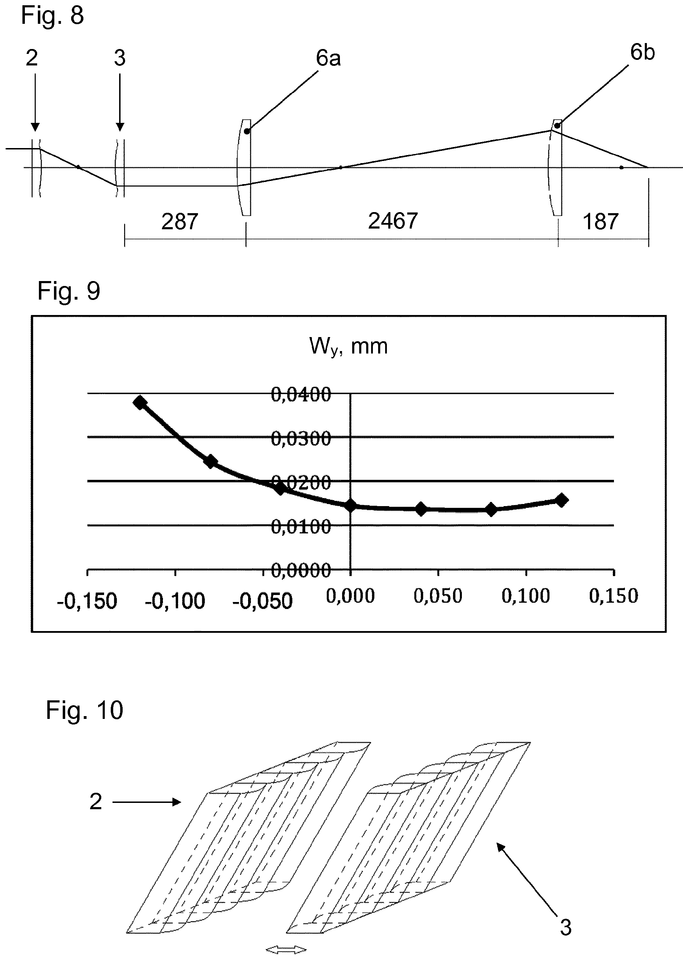

Die Bewegung der beiden Strahltransformationsvorrichtungen 2, 3 relativ zueinander ist in Fig. 10 angedeutet.

Die Linienbreite $w_y$ ist von der Divergenz abhängig. Dies soll an folgendem Beispiel erläutert werden:
Gegeben sei eine Strahltransformationsvorrichtung mit einem Pitch P=1,06mm, $f_T$ = 7,5mm, $\theta'_y$ =0,25mrad; eine als erste Fokussiermittel 6a dienende fokussierende Linse mit $f_1$=586mm und eine als zweite Fokussiermittel 6b dienende Projektionslinse mit $f_2$=170mm sowie mit der Vergrößerung V=S'/S =(2467-586)/187 =1/10,06 (siehe Fig. 8). Die in der Fig. 8 angegebenen Maße sind Abstände in mm.

Die Änderung des Abstandes der Strahltransformationsvorrichtungen in dem Bereich $\Delta$ = +0,04 ... -0,12 mm ändert die Linienbreite $w_y$ = HW@$e^{-2}$ von 14 $\mu$m auf 38 $\mu$m (siehe Fig. 9). Eine solche Verschiebung ist problemlos mit passenden Präzisionsmechaniken möglich. Auch präzise elektro-mechanische, beispielsweise Piezoantriebe sind dafür gut geeignet.

**Patentansprüche**

1. Vorrichtung zur Erzeugung einer linienförmigen Intensitätsverteilung einer Laserstrahlung, umfassend

   - zwei Strahltransformationsvorrichtungen (2, 3), die zueinander beabstandet sind,
   - Fokussiermittel (6a, 6b), die die durch die beiden Strahltransformationsvorrichtungen (2, 3) hindurch getretene Laserstrahlung in eine linienförmige Intensitätsverteilung fokussieren können,

   **dadurch gekennzeichnet, dass** die Vorrichtung derart gestaltet ist, dass die Linienbreite in Linienquerrichtung der linienförmigen Intensitätsverteilung durch Veränderung des Abstands zwischen den beiden Strahltransformationsvorrichtungen (2, 3) verändert werden kann.

2. Vorrichtung nach Anspruch 1, **dadurch gekennzeichnet, dass** eine oder beide der Strahltransformationsvorrichtungen (2, 3) die Laserstrahlung drehen können, insbesondere um einen Winkel von 90° um die Ausbreitungsrichtung, und/oder das eine oder beide der Strahltransformationsvorrichtungen (2, 3) die Laserstrahlung derart transformieren können, dass die Divergenz oder die Beugungsmaßzahl von zwei zueinander senkrechten Querrichtungen der Laserstrahlungen vertauscht werden.

3. Vorrichtung nach einem der Ansprüche 1 oder 2, **dadurch gekennzeichnet, dass** eine oder beide der Strahltransformationsvorrichtungen (2, 3) als Linsenarray oder als Spiegelarray ausgebildet sind.

4. Vorrichtung nach Anspruch 3, **dadurch gekennzeichnet, dass** bei dem Linsenarray die Linsen als Zylinderlinsen ausgebildet sind, deren Zylinderachsen insbesondere unter einem Winkel von 45° zu der Richtung ausgerichtet sind, in der die Linsen nebeneinander angeordnet sind.

5. Vorrichtung nach Anspruch 3, **dadurch gekennzeichnet, dass** bei dem Spiegelarray die Spiegel eine konkave Krümmung aufweisen.

6. Vorrichtung nach einem der Ansprüche 1 bis 5, **dadurch gekennzeichnet, dass** die Vorrichtung eine Laserlichtquelle (10) umfasst, die beispielsweise als von Laserdioden gepumpter Festkörperlaser ausgebildet ist.

7. Vorrichtung nach einem der Ansprüche 1 bis 6, **dadurch gekennzeichnet, dass** die Vorrichtung Homogenisatormittel (4) umfasst, die insbesondere zwischen den beiden Strahltransformationsvorrichtungen (2, 3) und den Fokussiermitteln angeordnet sind.

8. Vorrichtung nach einem der Ansprüche 1 bis 7, **dadurch gekennzeichnet, dass** die Vorrichtung ein Teleskop, insbesondere ein anamorphotisches Teleskop (1), umfasst, das vorzugsweise zwischen der Laserlichtquelle (10) und den beiden Strahltransformationsvorrichtungen(2, 3) angeordnet ist.

9. Vorrichtung nach einem der Ansprüche 1 bis 8, **dadurch gekennzeichnet, dass** die Vorrichtung Positioniermittel umfasst, die den Abstand der beiden Strahltransformationsvorrichtungen (2, 3) verändern können, insbesondere indem eine der beiden Strahltransformationsvorrichtungen (2, 3) relativ zu der anderen bewegt wird.

10. Vorrichtung nach Anspruch 9, **dadurch gekennzeichnet, dass** die Positioniermittel als Präzisionsmechanik oder als elektromechanischer Antrieb, beispielsweise als Piezoantrieb, ausgebildet sind.

Fig. 2

y

x

7

Fig. 3a

A

B

D

C

Fig. 3b

C

B

D

A

Fig. 4a

9

9

9

9

y

x

Fig. 4b

9'

9'

Fig. 5

Fig. 6

Fig. 7

Fig. 8

| 287 | 2467 | 187 |

Fig. 9

$W_y$, mm

0,0400

0,0300

0,0200

0,0100

0,0000

-0,150   -0,100   -0,050   0,000   0,050   0,100   0,150

Fig. 10

Fig. 1a

Fig. 1b

EP 3 428 713 A1

Europäisches
Patentamt

European
Patent Office

Office européen
des brevets

**EUROPÄISCHER RECHERCHENBERICHT**

Nummer der Anmeldung

EP 18 17 9273

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2008 033358 A1 (COHERENT GMBH [DE]) 26. Februar 2009 (2009-02-26) | 1-4,6-8 | INV. G02B27/09 B23K26/073 |
| Y | * Absätze [0006], [0008], [0011], [0022], [0034], [0059] - [0061]; Abbildungen 2,16,17 * | 5,9,10 | |
| | ----- | | |
| Y | US 5 331 466 A (VAN SAARLOOS PAUL P [AU]) 19. Juli 1994 (1994-07-19) * Zusammenfassung; Abbildungen 6,7 * * Spalte 4, Zeile 65 - Spalte 6, Zeile 12 * | 5 | |
| | ----- | | |
| Y | US 2012/013880 A1 (CHOI JIN [KR] ET AL) 19. Januar 2012 (2012-01-19) * Absätze [0031] - [0040]; Abbildung 1 * | 9,10 | |
| | ----- | | |

**RECHERCHIERTE SACHGEBIETE (IPC)**

G02B
B23K

Der vorliegende Recherchenbericht wurde für alle Patentansprüche erstellt

| Recherchenort | Abschlußdatum der Recherche | Prüfer |
|---|---|---|
| München | 15. November 2018 | Blau, Gerd |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes
   Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 18 17 9273

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-11-2018

| Im Recherchenbericht angeführtes Patentdokument | Datum der Veröffentlichung | Mitglied(er) der Patentfamilie | Datum der Veröffentlichung |
|---|---|---|---|
| DE 102008033358 A1 | 26-02-2009 | KEINE | |
| US 5331466 A | 19-07-1994 | KEINE | |
| US 2012013880 A1 | 19-01-2012 | KR 20120006812 A<br>US 2012013880 A1 | 19-01-2012<br>19-01-2012 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1896893 A1
- US 5513201 A

- EP 1006382 A1